# EUROPEAN PATENT APPLICATION

(11) **EP 4 730 036 A1**
(43) Date of publication of application: **22.04.2026**
(21) Application number: 24207102.5
(22) Date of filing: 17.10.2024
(51) Int. Cl.: G03F 7/20

(54) **METHOD OF FEED-FORWARD CORRECTION, AND COMPUTER PROGRAM FOR FEED-FORWARD CORRECTION**

(71) Applicant: ASML Netherlands B.V., 5500 AH Veldhoven (NL)
(72) Inventor: BECKERS, Jasper, Pierre, 5500 AH Veldhoven (NL); BAJONERO CANONICO, Emilio, 5500 AH Veldhoven (NL); JANSEN, Rick, 5500 AH Veldhoven (NL); RADEMAKER, Justin, 5500 AH Veldhoven (NL)
(74) Representative: ASML Netherlands B.V.

(57) **Abstract**

A method of feed-forward correction comprising: determining feed-forward corrections based on measurements on a patterning device of a lithographic apparatus of a deformation parameter indicative of deformation of the patterning device before and after exposure by the lithographic apparatus of a substrate of a first series of substrates, wherein the feed-forward corrections are to be applied during exposure by the lithographic apparatus of a substrate of a second series of substrates.

## Description

### FIELD

The present invention relates to techniques of feed-forward correction, particularly for errors due to heating of a patterning device.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as "Moore's law". To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm.

A lithographic apparatus may include an illumination system for providing a projection beam of radiation, and a support structure for supporting a patterning device. The patterning device may serve to impart the projection beam with a pattern in its cross-section. The apparatus may also include a projection system for projecting the patterned beam onto a target portion of a substrate.

The patterning device may deform during use. The patterning device may be aligned before the patterned beam is projected onto the substrate so as to partly account for the deformation of the patterning device.

### SUMMARY OF THE INVENTION

An object of the present invention is to more accurately reduce errors caused by deformation of the patterning device.

In accordance with the present invention, there is disclosed a method of feed-forward correction comprising: determining feed-forward corrections based on measurements on a patterning device of a lithographic apparatus of a deformation parameter indicative of deformation of the patterning device before and after exposure by the lithographic apparatus of a substrate of a first series of substrates, wherein the feed-forward corrections are to be applied during exposure by the lithographic apparatus of a substrate of a second series of substrates.

In accordance with the present invention, there is disclosed a controller for a lithographic apparatus for exposing substrates with radiation patterned by a patterning device, wherein the controller is configured to determine feed-forward corrections based on measurements on the patterning device of a deformation parameter indicative of deformation of the patterning device before and after exposure by the lithographic apparatus of a substrate of a first series of substrates, wherein the feed-forward corrections are to be applied during exposure by the lithographic apparatus of a substrate of a second series of substrates.

### BRIEF DESCRIPTION OF THE DRAWINGS

Embodiments of the invention will now be described, by way of example only, with reference to the accompanying schematic drawings, in which corresponding reference symbols indicate corresponding parts.
Figure 1 schematically depicts a lithographic apparatus.
Figure 2a schematically depicts light from a patterning device alignment mark passing through a pellicle.
Figure 2b schematically depicts light from a patterning device stage alignment mark not passing through the pellicle.
Figure 3 is a graph showing the relationship between time and feed-forward corrections to account for deformation of the patterning device during exposure of each substrate deformation of the patterning device.
Figure 4 is a graph showing the relationship between time and measurements of deformation of the patterning device.
Figure 5 is a graph showing the relationship between time and error due to deformation of the patterning device.
Figure 6 is a diagram schematically depicting a method of applying feed-forward corrections.

The features shown in the Figures are not necessarily to scale, and the size and/or arrangement depicted is not limiting. It will be understood that the Figures include optional features which may not be essential to the invention. Furthermore, not all of the features of the apparatus are depicted in each of the figures, and the Figures may only show some of the components relevant for describing a particular feature.

### DETAILED DESCRIPTION

In the present document, the terms "radiation" and "beam" are used to encompass all types of electromagnetic radiation, including ultraviolet radiation (e.g., with a wavelength of 436, 405, 365, 248, 193, 157, 126 or 13.5 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

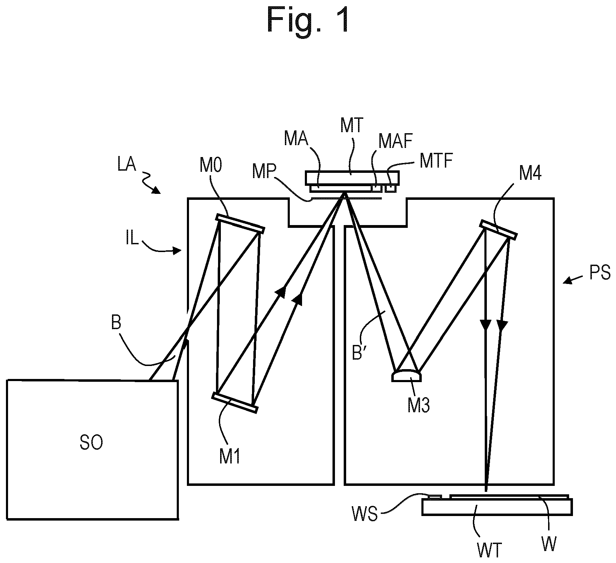

Figure 1 schematically depicts a lithographic apparatus LA. The lithographic apparatus LA includes an illumination system (also referred to as illuminator) IL configured to condition a radiation beam B (e.g., EUV radiation or DUV radiation) and a patterning device stage or mask support (e.g., a mask table) MT constructed to support a patterning device (e.g., a mask) MA. The patterning device stage MT may be connected to a first positioner (not depicted in Figure 1) configured to accurately position the patterning device MA in accordance with certain parameters. Figure 1 further shows a substrate support (e.g., a substrate table or a substrate holder) WT constructed to hold a substrate (e.g., a resist coated wafer) W. The substrate support WT may be connected to a second positioner (not depicted in Figure 1) configured to accurately position the substrate support WT in accordance with certain parameters. Figure 1 further shows a projection system (e.g., a refractive projection lens system or a reflective optics system) PS configured to project a pattern imparted to the radiation beam B' by patterning device MA onto a target portion (e.g., comprising one or more dies) of the substrate W.

In operation, the illumination system IL receives the radiation beam B from a radiation source SO, e.g., via a beam delivery system (not depicted in Figure 1). The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate W may be covered by an immersion liquid having a relatively high refractive index, e.g., water, so as to fill an immersion space between the projection system PS and the substrate W - which is also referred to as immersion lithography. More information on immersion techniques is given in US 6,952,253, which is incorporated herein by reference.

The lithographic apparatus LA may be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

The lithographic apparatus LA may comprise a measurement stage (not depicted in Figure 1). The measurement stage is arranged to hold a sensor. The sensor may be arranged to measure a property of the projection system PS or a property of the radiation beam B. The measurement stage may hold multiple sensors. The measurement stage may move beneath the projection system PS when the substrate support WT is away from the projection system PS.

In operation, the radiation beam B is incident on the patterning device, e.g., mask, MA which is held on the patterning device stage MT, and is patterned by the pattern (design layout) present on patterning device MA. Having traversed the mask MA, the radiation beam B passes through the projection system PS, which focuses the beam onto a target portion of the substrate W. With the aid of the second positioner and a position measurement system, the substrate support WT can be moved accurately, e.g., so as to position different target portions in the path of the radiation beam B at a focused and aligned position. Similarly, the first positioner and possibly another position sensor (which is not explicitly depicted in Figure 1) may be used to accurately position the patterning device MA with respect to the path of the radiation beam B. Patterning device MA and substrate W may be aligned using patterning device alignment mark MAF and substrate alignment marks. Although the substrate alignment marks occupy dedicated target portions, they may be located in spaces between target portions. Substrate alignment marks are known as scribe-lane alignment marks when these are located between the target portions or near the perimeter of the substrate.

In this specification, a Cartesian coordinate system is used. The Cartesian coordinate system has three axis, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

As noted above, the lithographic apparatus LA may be used to expose portions of a substrate W in order to form a pattern in the substrate W. In order to improve the accuracy with which a desired pattern is transferred to a substrate W, properties such as the alignment of the patterning device MA and/or the patterning device stage MT may be measured. Such alignments may include relative alignments, including the relative alignment between the patterning device MA and the patterning device stage MT, the relative alignment between the patterning device MA and the substrate support WT, and/or the relative alignment between the patterning device stage MT and the substrate support WT. These properties may be measured on a regular basis, often before exposure of each substrate W, and/or also after exposure of each substrate W, or may be measured less frequently, for example, as part of a calibration process.

Determining the relative alignment of the patterning device stage MT and the substrate support WT assists in projecting a patterned radiation beam onto a desired portion of a substrate W. This may be particularly important when projecting patterned radiation onto a substrate W which includes portions which have already been exposed to radiation, so as to improve alignment of the patterned radiation with the previously exposed regions.

The alignment measurements described above may be performed by illuminating an alignment mark MAF fixedly provided on the patterning device MA, and/or a stage alignment mark MTF fixedly provided on the patterning device stage MT as required. The image produced by the alignment marks may be captured by an optical system, such as an alignment sensor WS.

The patterning device alignment mark MAF and the stage alignment mark MTF may each have a reflective geometric pattern. Different geometric patterns may be suitable for different directions or fineness of alignments. Suitable geometric patterns include: a solid square or rectangle, pinhole features, diffraction gratings, and a chequerboard pattern, for example. Furthermore, more than one alignment mark may be provided on each of the patterning device MA and the patterning device stage MT. It should also be understood that marks for other purposes than alignment (such as marks for aberration detection) may also be present.

As shown in Figure 1, the patterning device alignment mark MAF may form part of a patterning device MA. One or more such alignment mark MAF may be provided on patterning devices MA used to perform lithographic exposures. An alignment mark MAF may be positioned outside of a patterned region of the patterning device MA, which is illuminated with radiation during a lithographic exposure. As noted above, multiple alignment marks MAF, MTF may be provided on each of the patterning device MA and the patterning device stage MT. An alignment operation may make use of one, several, or all of these alignment marks MAF, MTF. For example, each of the alignment marks MAF, MTF may comprise a dedicated piece of hardware, sometimes referred to as a "fiducial". In some implementations, the patterning device alignment mark MAF may be etched directly into the patterning device MA, alongside the patterned region of the patterning device MA. For the purposes of this description, a fiducial is considered to be an example of an alignment mark.

As shown in Figure 1, the lithographic apparatus LA may be an EUV lithographic apparatus and therefore uses a reflective patterning device MA. The patterning device alignment mark MAF may thus be of the reflective type. In other lithography technologies, the patterning device MA may be transmissive, and the patterning device alignment mark MAF may accordingly also be transmissive. It should be understood that the present invention can be implemented with either reflective or transmissive alignment marks, depending on the lithography technology employed.

In order to measure alignment of the patterning device MA and the patterning device stage MT, an alignment sensor WS (as shown schematically in Figure 1) may be provided to measure light B' which is output from the projection system PS. The alignment sensor WS may, for example, be provided on or attached to the substrate support WT as shown in Figure 1. In order to perform an alignment process, the patterning device stage MT may be positioned such that the stage alignment mark MTF is illuminated with light B from the illumination system IL and the image of the stage alignment mark MTF is measured by the alignment sensor WS; and, separately, the patterning device stage MT may be positioned such that the patterning device alignment mark MAF is illuminated with light B from the illumination system IL and the image of the patterning device alignment mark MAF is measured by the alignment sensor WS. The substrate support WT may be positioned such that radiation which is reflected from the alignment marks MAF, MTF is projected, by the projection system PS, onto the alignment sensor WS.

The position of the alignment feature in the radiation beam B may be measured by an alignment sensor WS positioned at a substrate W level (e.g. provided on or attached to the substrate support WT as shown in Figure 1). The alignment sensor WS may be operable to detect the position of an alignment feature in the radiation incident upon it. This may allow the alignment of the substrate support WT relative to the stage alignment mark MTF and/or the patterning device alignment mark MAF to be determined. With knowledge of the relative alignment of the patterning device MA, and/or the patterning device stage MT, and/or the substrate support WT, the patterning device MA and the substrate support WT may be moved relative to each other so as to form a pattern (using the patterned radiation beam B' reflected from the patterning device MA) at a desired location on the substrate W. The position of the substrate W on the substrate support WT may be determined using a separate measurement process.

During exposure cycles, various contaminant particles may be generated. As shown in Figure 1, a pellicle MP may be positioned to cover the patterning device MA and the patterning device alignment mark MAF, but may leave the stage alignment mark MTF uncovered. As a result, light B' from the patterning device alignment mark MAF will pass through the pellicle MP (if present) before reaching the alignment sensor WS, whereas light from the stage alignment mark MTF will not pass through the pellicle MP (even if one is present) before reaching the alignment sensor WS. In other words, the pellicle MP may be positioned such that the pellicle MP intersects the light path between the alignment sensor WS and the patterning device alignment mark MAF, and does not intersect the light path between the alignment sensor WS and the stage alignment mark MTF. Similarly, in embodiments where the patterning device MA is of the reflective type, light beam B from the illumination system IL would pass through the pellicle MP (if present and intact) before reaching the patterning device alignment mark MAF, but would not pass through the pellicle MP (even if one is present) before reaching the stage alignment mark MTF.

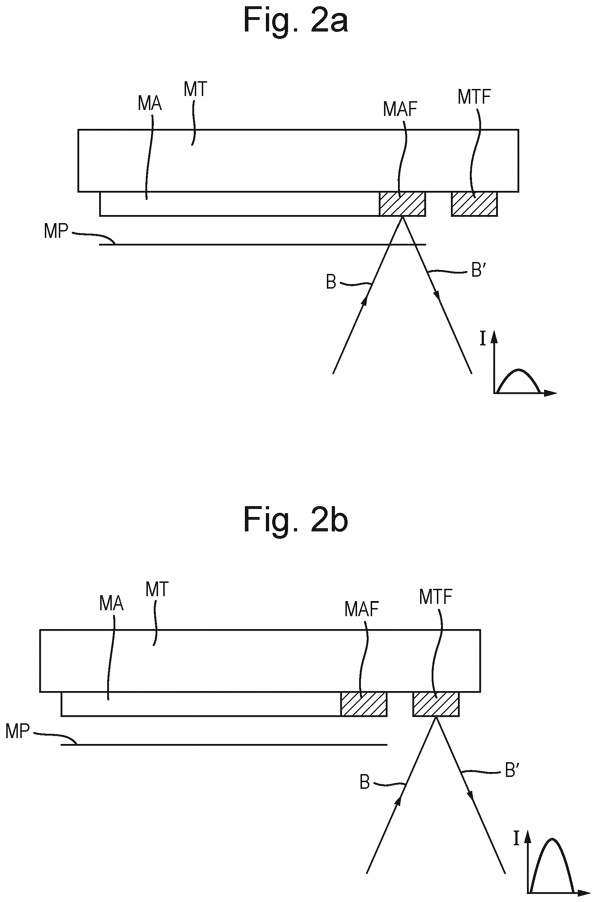

As shown in Figure 2a, when the patterning device stage MT is positioned so that the patterning device alignment mark MAF is exposed to light B from the illumination system IL, the light B' from the patterning device alignment mark MAF will pass through the pellicle MP. In case the patterning device MA is of the reflective type, such as shown in Figure 2a, the light B from the illumination system IL will also pass through the pellicle MP before reaching the patterning device alignment mark MAF. Therefore, in case the patterning device MA is of the reflective type, light B from the illumination system IL will pass through the pellicle twice before reaching the alignment sensor WS. In either case, whether the light B passes through the pellicle MP once (in case of a transmissive patterning device MA) or twice (in case of a reflective patterning device MA), the reflected light B' will be attenuated somewhat by the pellicle MP. As a result, as shown in Figure 2a, the intensity of the light B' detected by the alignment sensor WS may be relatively low.

By contrast, as shown in Figure 2b, when the patterning device stage MT has displaced to a position such that the stage alignment mark MTF is exposed to light B from the illumination system IL, the light B reaches and leaves the stage alignment mark MTF without passing through the pellicle MP. As a result, the intensity of the light B' detected by the alignment sensor WS may be relatively high.

In order to selectively expose the patterning device alignment mark MAF and the stage alignment mark MTF, the relative position between the light beam B and the patterning device stage MT may be adjusted. That is, the relative position may be adjusted so that at least a portion of the light beam B is incident on the stage alignment mark MTF, the reflection of which being measured as a detection intensity. The relative position may be adjusted so that at least a portion of the light beam B is incident on the patterning device alignment mark MAF, the reflection of which being measured as another detection intensity.

When the image of an alignment mark MAF, MTF is captured by the alignment sensor WS as discussed above, the intensity *I* that the alignment sensor WS measures may depend on: the average source power from the illumination system IL during the measurement, the sensor responsivity, the specific illumination settings (e.g. the pupil transmission and slit position dependency), the transmission of the projection system PS, the transmission of the dynamic gas lock membrane and the pellicle transmission, the optical properties of the alignment mark including the size of the projected mark image, the reflectivity of the reflector mark, the size of the alignment sensor WS, the reflectivity of the light absorber around the reflective portion of the mark (assuming that the size of the alignment sensor WS is larger than the image), and the measurement uncertainty. The alignment marks MAF, MTF may be of a square shape, but it should be understood that alignment marks of other shapes can be used.

The intensity may scale linearly with the source power and be proportional to the transmission values of the various components along the optical column (i.e. from the patterning device MA through to the substrate W, including any intervening mirrors M0, M1, M3, M4 and other optical components).

In an embodiment there is provided a method of feed-forward correction. The method may be performed by a lithographic apparatus LA such as the lithographic apparatus LA shown in Figure 1. For example, the method may be performed by a controller of the lithographic apparatus LA.

In an embodiment the lithographic apparatus LA is configured to expose a plurality of substrates W. For example, the lithographic apparatus LA may expose a series of substrates W. A series of substrates W may be a plurality of substrates W that are exposed during a period. The number of substrates W in a series of substrates W may be, for example, at least five, optionally at least 10, optionally at least 20. The number of substrates W within a series may be, for example, at most 100, optionally at most 50. For example, a series of substrates W may comprise 25 substrates W.

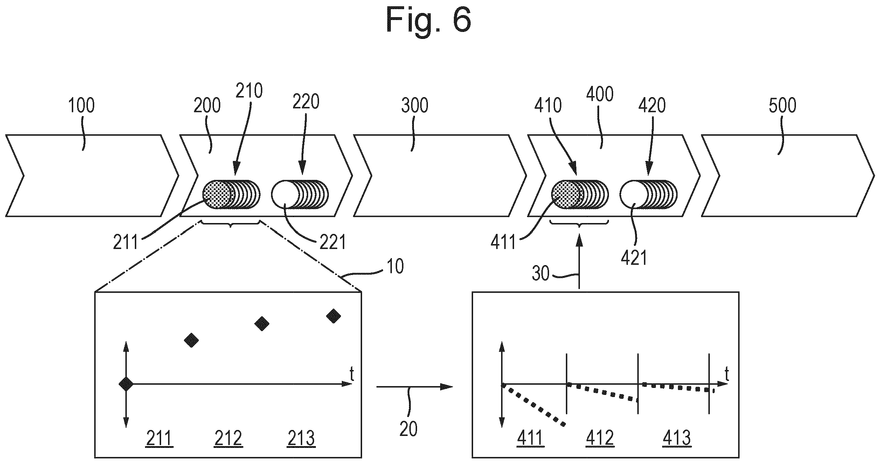

Figure 6 is a diagram schematically depicting a method of applying feed-forward corrections. As shown in Figure 6, in an embodiment the lithographic apparatus LA is configured to expose a plurality of series 210, 220 of substrates W within a period 200. Within one period 200, the same patterning device MA may be used to pattern the radiation with which the substrates W are exposed. After such a period 200, the patterning device MA may be exchanged for another patterning device MA. In a further subsequent period 400, the first patterning device MA may be used again by the lithographic apparatus LA.

In an embodiment the method of feed-forward correction comprises measuring a deformation parameter before and after exposure of a substrate 211 of a first series 210 of substrates W. In an embodiment the measuring is performed by a sensor of the lithographic apparatus LA such as the alignment sensor WS. The measuring is performed on the patterning device MA. The measurement is a measurement of the patterning device MA. This is different from performing a measurement on a different component such as the substrate. The deformation parameter is indicative of deformation of the patterning device MA of the lithographic apparatus LA. For example, the deformation parameter may be a location of the patterning device alignment mark MAF measured by the alignment sensor WS. Additionally or alternatively, the deformation parameter may be a material property of the patterning device MA.

In an embodiment the alignment sensor WS measures the deformation parameter shortly before exposure of each substrate W within a series 210 of substrates W. For example, the alignment sensor WS may measure the location of the patterning device alignment mark MAF shortly before exposure of the first substrate 211 of the first series 210 of substrates W. The alignment sensor WS may measure the deformation parameter again shortly before the second substrate of the first series 210 of substrates W. The measurement made shortly before exposure of the second substrate is performed after exposure of the first substrate 211. Accordingly, the deformation parameter is measured before and after exposure of the first substrate 211.

In an embodiment the deformation parameter is measured before and after exposure of each of a plurality of substrates of the first series 210 of substrates W. For example, the deformation parameter may be measured before and after exposure of each and every substrate of the first series 210 of substrates W. In an alternative embodiment, the deformation parameter is not measured after exposure of the last substrate of the series of substrates W.

The measurement of the location of the patterning device alignment mark MAF is indicative of the deformation of the patterning device MA. The patterning device MA may deform due to heating and/or cooling of the patterning device MA. For example, in general the patterning device MA may be expected to expand when the patterning device MA heats up. The patterning device MA may be expected to contract when the patterning device MA cools down.

When the patterning device MA deforms, this can lead to errors in exposure of a substrate W. For example, when the patterning device MA expands or contracts, the magnification of the patterned radiation on the substrate W may be undesirably affected. Undesirable overlay can increase.

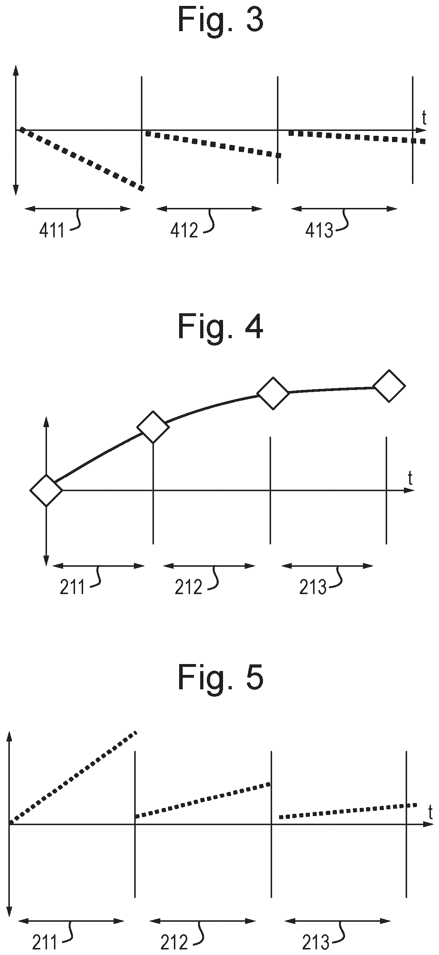

In an embodiment the method of feed-forward correction comprises determining the feed-forward corrections based on measurements of the deformation parameter before and after exposure of the substrate of the first series 210 of substrates W. In an embodiment the feed-forward corrections are to be applied during exposure by the lithographic apparatus LA of a substrate 411 of a second series 410 of substrates W. For example, Figure 3 is a graph showing the relationship between time and the determined feed-forward corrections. In Figure 3, the X axis corresponds to time. The Y axis is a measure of the feed-forward corrections. Figure 3 shows the feed-forward corrections that are to be applied during exposure of each of three successive substrates 411, 412, 413.

As shown in Figure 3, the feed-forward corrections are applied during exposure of each of the three substrates 411, 412, 413. A plurality of feed-forward corrections may be applied during exposure of each substrate 411, 412, 413. For example, a plurality of feed-forward corrections may be applied during exposure of substrate 411. A different plurality of feed-forward corrections may be applied during exposure of substrate 412. A different plurality of feed-forward corrections may be applied during exposure of substrate 413. The feed-forward corrections may vary during the exposure of each substrate W. For example, the feed-forward corrections are to be applied to exposure of respective fields of the substrate 411, 412, 413 of a second series 410 of substrates.

In an embodiment the feed-forward corrections are applied by adjusting one or more parameters of the lithographic apparatus LA for the exposure of the substrate W. For example, in an embodiment the feed-forward corrections are applied by adjusting focus settings of the lithographic apparatus LA. In an embodiment the feed-forward corrections are to be applied by controlling at least one optical element (e.g. lens and/or mirror) of the lithographic apparatus LA. By applying the feed-forward corrections, the deformation of the patterning device MA may be at least partly compensated for. In an embodiment the feed-forward corrections are applied by moving the substrate table WT for moving the substrate W. In an embodiment the feed-forward corrections are applied by moving the support structure MT for moving the patterning device MA. For example, the substrate table WT and/or the support structure MT may be moved so as to adjust the effective magnification of the lithographic apparatus LA.

An embodiment of the invention is expected to achieve an improvement in accuracy of exposing a substrate W with patterned radiation.

Figure 4 is a graph showing the relationship between time and deformation of the patterning device MA due to heating. Figure 4 shows the deformation generally increasing during use of the patterning device MA for exposing three substrates 211, 212, 213 of a first series 210 of substrates W. The deformation may be caused by heating of the patterning device MA. As shown in Figure 4, within the time for exposing a given substrate W, the pattern device MA may be deformed, which can lead to focussing errors. In an embodiment a plurality of targets or fields on each substrate W is exposed. Depending on when a given target or field is exposed during the exposure period for a given substrate W, the shape of the patterning device MA may be slightly different. As can be seen in Figure 4, in general, the first substrate 211 within the first series 210 may experience the greatest deformation during its exposure. Subsequent substrates 212, 213 may experience changes in deformation of the patterning device MA, albeit to a lesser extent. In general, after several substrates W within the series 210 have been exposed, the variation in deformation of the patterning device MA during exposure of that substrate may be expected to be substantially similar to other substrates within the series.

Figure 5 schematically depicts the relationship between time and error (e.g. overlay) for the substrates 211, 212, 213 represented in Figure 4. As shown in Figure 5, the error may generally increase during exposure of a given substrate.

In an embodiment the method comprises determining a pre-exposure correction based on the measurement of the deformation parameter before the exposure of the substrate of the first series 210 of substrates W. The pre-exposure correction is to be applied before the exposure of the substrate. For example, as mentioned above, the deformation parameter may be measured shortly before exposure of each of the substrates 211, 212, 213. These measurements may be represented by the diamond points shown in Figure 4, for example. Based on these measurements, the pre-exposure correction may be made shortly before exposure of subsequent substrates 212, 213. As a result, as shown in Figure 3, the error at the start of exposure of the subsequent substrates 212, 213 is small. However, during exposure of those substrates 212, 213, the error gradually increases due to the heating of the patterning device MA.

Based on the measurements of the deformation parameter, the expected errors during exposure of substrates of a subsequent series may be predicted. In an embodiment the method comprises inputting the measurements into a model such that the model outputs the feed-forward corrections. For example, it may be predicted that the first substrate 411 of a second series 410 of substrates W may experience a similar change in error during exposure as the first substrate 211 of the first series 210 of substrates W. This is because the thermal conditions for the first substrate within each series may be expected to be substantially similar. At the beginning of each series of substrates, the temperature of the patterning device MA may be substantially the same. The measurements made before and after exposure of the first substrate 211 of the first series 210 of substrates may be used to determine the feed-forward corrections to be applied to the first substrate 411 of the second series 410 of substrates W.

It is not essential for the method to comprise measuring the deformation parameter. In an alternative embodiment, the measurements of the deformation parameter have already been made. The method may comprise using the measurements that have already been made in order to determine the feed-forward corrections.

In an embodiment the method comprises applying the feed-forward corrections to exposure of the substrate of the second series 410 of substrates W. For example, as shown in Figure 3 the feed-forward corrections may be applied to a plurality of substrates 411, 412, 413 of the second series 410 of substrates W.

In an embodiment the lithographic apparatus LA uses the same patterning device MA when exposing both the first series 210 and the second series 410 of substrates W. That is, the patterning device MA used when the measurements of the deformation are made is the same patterning device MA that is used when the feed-forward corrections are applied.

Figure 6 schematically depicts application of an embodiment of the method. As shown in Figure 6, in an embodiment the lithographic apparatus LA exposes substrates W during successive periods 100, 200, 300, 400, 500. Within each period, the lithographic apparatus LA may expose one or more series of substrates W. For example, during the second period 200, the lithographic apparatus LA exposes the first series 210 of substrates W and a subsequent series 220 of substrates W. During the fourth period 400, the lithographic apparatus LA exposes the second series 410 of substrates W and a subsequent series 420 of substrates W. During the first period 100, the third period 300 and the fifth period 500, the lithographic apparatus LA may use one or more other patterning devices to pattern the radiation for exposing substrates W.

As shown in Figure 6, measurements 10 may be made of the deformation parameter when the first series 210 of substrates are exposed. Measurements may be made before and after each of the substrates 211, 212, 213 of the first series 210 of substrates W.

In an embodiment, based on these measurements the feed-forward corrections may be determined as indicated by the arrow 20. The feed-forward corrections are to be applied to the successive substrates 411, 412, 413 of the second series 410 of substrates W. The feed-forward corrections may be applied as indicated by the arrow 30 in Figure 6.

In an embodiment the deformation parameter of the patterning device MA before exposure of the substrate 411 to which the feed-forward corrections are to be applied is similar to the deformation parameter of the patterning device MA measured before exposure of the substrate 211 of the first series 210 of substrates W. For example, the feed-forward corrections may be applied to the first substrate 411 of the second series 410 based on measurements made before and after exposure of the first substrate 211 of the first series 210 of substrates W. Both the second series 410 and the first series 210 may be the first series of substrates within their respective periods 400, 200. As such, the thermal condition of the patterning device MA may be expected to be substantially similar for the first substrate 411 of the second series 410 as for the first substrate 211 of the first series 210. The measured deformation from the first substrate 211 of the first series 210 may be expected to indicate where the expected formation related to exposure of the first substrate 411 of the second series 410.

The temperature of the patterning device MA may be expected to be similar for both the first substrates 211, 411. The same patterning device MA is used. The same target arrangement of patterns may be intended for both the first substrates 211, 411.

There may be some difference between the deformation parameter immediately before each of the first substrates 211, 411 is exposed. In an embodiment a difference between the deformation parameter measured before exposure of the substrate 211 of the first series 210 and the deformation parameter before exposure of the substrate 411 to which the feed-forward corrections are to be applied is less than a difference between the deformation parameter before exposure of the substrate 411 to which the feed-forward corrections are applied and the deformation parameter before exposure of another substrate 412, 413 of the second series 410 of substrates W. For example, the thermal conditions of the patterning device MA for exposure of the substrate 411 may be more similar to the thermal conditions for exposure of the substrate 211 than to the thermal conditions for exposure of the subsequent substrates 412, 413.

In an embodiment the substrate 211 of the first series 210 of substrates is an nth substrate of the first series 210 of substrates. The substrate 411 of the second series 410 to which the feed-forward corrections are to be applied is the nth substrate of the second series 410 of substrates W. For example, the measurements for the first substrate 211 may be used to determine the feed-forward corrections for the correspondingly first substrate 411 to which the feed-forward corrections are to be applied. The measurements made before and after exposure of the second substrate 212 may be used to determine the feed-forward corrections to be applied to the second substrate 412 of the second series 410 of substrates W.

As indicated in Figure 4, the variation in deformation of the patterning device MA within a time period for exposing a single substrate may be approximately linear. In an embodiment the method comprises interpolating between the measured deformation parameter before the exposure and the measured deformation parameter after the exposure so as to determine the feed-forward corrections. For example, Figure 3 shows feed-forward correction that varies substantially linearly within the exposure period for a single substrate. An embodiment of the invention is expected to allow feed-forward correction without requiring complicated calculations.

The measurements made by the alignment sensor WS may be made in order to apply the pre-exposure corrections. The feed-forward corrections for correcting within the exposure period for each individual substrate may be determined based on measurements that are already made in the normal functioning of the lithographic apparatus LA. An embodiment of the invention is expected to improve accuracy of exposure without increasing throughput. An embodiment of the invention is expected to improve accuracy of exposure without requiring different apparatus to be used.

It is not essential for the interpolation to be linear. In an alternative arrangement, the interpolation takes into account the non-linear variation of deformation of the patterning device MA during exposure of a single substrate. For example, Figure 4 shows an expected slight curve in the heating of the patterning device MA during exposure of each substrate. By taking into account non-linear variations, the accuracy of exposure may be further improved. In an embodiment a model is used that simulates the field-to-field corrections based on the collected deformation data before and after exposure. Exposure timing information may be used to determine when the patterning device MA is cooling and when the patterning device MA is heating up. Use of the exposure timing information can help to further improve accuracy.

After exposure of each substrate 211, 212, 213 within a series 210 of substrates W, there may be a short pause when the patterning device MA is not irradiated with radiation. During this time period, the patterning device MA may cool down slightly, reducing its deformation. In an embodiment the method comprises applying a scaling factor to at least one of the measurements so as to account for change of the deformation parameter between when one of the measurements is made and when the exposure begins or ends. For example, when there is a gap between the end of exposure of the first substrate 211 and when the deformation parameter is measured, then a scaling factor may be applied to the measurement made after the exposure so as to take into account the cooling down of the patterning device MA during the time period when the patterning device MA is not irradiated between exposure of the first substrate 211 and exposure of the second substrate 212. An embodiment of the invention is expected to improve accuracy of feed-forward corrections.

As shown in Figure 4, in general, the greatest changes in deformation of the patterning device MA during exposure of a single substrate is expected to be greatest near the beginning of a series 210 of substrates W to be exposed. For example, the patterning device MA may be expected to have its lowest temperature just before exposure of the first substrate 211 of the series 210. During exposure of the first substrate 211, the greatest change in deformation of the patterning device MA may be experienced, as shown in Figure 4. The change in heating of the patterning device MA may generally decrease with successive substrates. After several substrates, a repeating pattern of heating of the patterning device MA during exposure followed by cooling of the patterning device MA between successive exposures may be expected.

In an embodiment the substrate 411 of the second series 410 of substrates W to which the feed-forward corrections are to be applied is to be exposed near a beginning of a time period for exposing the second series 410 of substrates W. In an embodiment the feed-forward corrections are determined for a subset of the first series 210 of substrates W, and to be applied to a corresponding subset of the second series 410 of substrates W. For example, the process of determining and applying the feed-forward corrections may be applied to only some of the substrates within a series of substrates W.

In an embodiment the time period follows loading of the patterning device MA for use in the exposure of the second series 410 of substrates. For example, the feed-forward corrections may be applied near the beginning of the period 400.

In an embodiment the time period follows an interval of at least a predetermined length after use of the patterning device MA for exposing any substrate. For example, the feed-forward corrections may be used only when it is determined that the patterning device MA has significantly cooled down such that the expected intra-substrate deformations are expected to be significant.

For example, in an embodiment the feed-forward corrections are determined for only the first few, for example the first two, or the first five substrates of the first series 210 and are applied to the corresponding first two, or first five substrates of the second series 410. The first few substrates experience the greatest changes in deformation during their exposure. An embodiment of the invention is expected to improve accuracy of exposure particularly for the first few substrates of a given series of substrates to be exposed. The method may be applied only when the greatest benefit may be seen.

In an embodiment, there is an inter-series pause between exposing successive series of substrates. For example, there may be an inter-series pause between exposing the first series 210 of substrates and the successive series 220 of substrates W. In an embodiment there may be an inter-substrate pause between exposing successive substrates within a series of substrates. For example, there may be an inter-substrate pause between exposing the first substrate 211 and the second substrate 212 of the first series 210 of substrates. In an embodiment the inter-series pause is longer than the inter-substrate pause. The patterning device MA may be expected to cool down more during the inter-series pause than during the inter-substrate pause. In an alternative embodiment the inter-series pause is shorter than at least one inter-substrate pause.

As shown in Figure 6, in an embodiment the feed-forward corrections determined from a nth substrate exposed during a period 200 for exposing one or more series 210, 220 of substrates W is used for determining the feed-forward corrections to be applied to the nth substrate 411 exposed during a later period 400 for exposing one or more series 410, 420 of substrates W. In an alternative embodiment, the feed-forward corrections may be determined based on measurements from a first series 210 of substrates and applied to a subsequent series 220 of substrates W within the same period 200 (i.e. without the patterning device MA being exchanged between the series 210, 220). For example, feed-forward corrections may be determined based on measurements for the first substrate 211 of the first series 210 and applied to the first substrate 221 of the successive series 220. Similarly, feed-forward corrections may be determined based on measurements for the first substrate 411 of the second series 410 and applied to the first substrate 421 of the successive series 420 of substrates W.

As explained, the pattern of heating of the patterning device MA during exposure of each substrate may be expected to fall into a steady state pattern after several substrates of a given series of being exposed. There may be a substantially repeating pattern of the patterning device MA heating up during exposure of a substrate followed by its cooling. In an embodiment the method comprises taking into account this repeated pattern so as to apply corrections to substantially eliminate the repeated pattern from the overall variation in deformation of the patterning device MA during exposure of a series of substrates. The feed-forward corrections are expected to reduce the residual errors that remain after the repeating pattern of heating and cooling of the patterning devices taken into account. In particular, the pattern of heating and cooling of the patterning device MA is less repetitive for the first few substrates within a given series of substrates. An embodiment of the invention is expected to reduce errors due to heating of the patterning device MA particularly during the first few substrates of a series of substrates to be exposed.

Of course, there may be some error remaining after the feed-forward corrections have been applied. Some errors may remain non-correctable.

The measurements may be referred to as alignment data, or reticle (e.g. patterning device) alignment data. In an embodiment the controller feeds the measurements to a model. The model may be configured to predict field-to-field distortions of the fields to be imaged onto the nth wafer of the second series 410. A plurality of fields on each substrate may be exposed. In an embodiment a different feed-forward correction may be applied to each field or to each of a plurality of groups of fields to be exposed of the substrate W. The model may be referred to as a heating model, for example, an intra substrate overlay drift reticle heating model. The feed-forward corrections may be expressed as magnification corrections of magnification settings of the projection system of the lithographic apparatus LA.

In an embodiment the reticle align data from a previous series 210 for a given patterning device MA are fed into a model to give corrections per substrate of a subsequent series 220, 410, 420. The interpolation may correlate the nth substrate of the first series 210 to the same nth substrate of the subsequent series 220, 410, 420.

In an embodiment the measurements comprise the difference in magnification in orthogonal directions within the plane of the patterning device MA. These measurements may be used to determine scaling factors. The scaling factors may be fed into the controller to adjust the stage and/or the optical trajectory such that overlay caused by heating of the patterning device MA is compensated for. The correction parameters are then used to expose the real production substrates. The field to field drift within a substrate W may be corrected for.

The present method may be performed using various types of alignment sensors WS. For example, the alignment sensor WS may comprise a transmission image sensor (TIS). Detailed disclosure of TIS may be found in US 6888151 B2, WO 2022207259 A1 and WO 2017207512 A2, for example, all of which are incorporated herein by reference.

Additionally or alternatively, the alignment sensor WS may comprise a shearing interferometer phase-stepping measurement sensor (PARIS). Detailed disclosure of PARIS may be found in : WO 2021069147 A1, WO 2022248154 A1 and WO 2022268679 A1, all of which are incorporated herein by reference. Furthermore, each of the stage alignment mark MTF and the patterning device alignment mark MAF may comprise orthogonal gratings, for use with the PARIS.

Furthermore, in an embodiment of PARIS, also known as Parallel ILIAS, multiple pairs (e.g. seven pairs) of detectors may be used simultaneously. In this embodiment, the PARIS can measure a corresponding plurality of (e.g. seven) alignment marks MAF fixedly provided on the patterning device MA. Furthermore, the patterning device alignment marks MAF may be dispersed across the full width of the light bean B'.

In addition to a method of feed-forward correction, there is also disclosed a method of manufacturing devices comprising the method of feed-forward correction disclosed above.

There is also disclosed a computer program comprising instructions to cause a lithographic apparatus to perform the method of feed-forward correction disclosed above.

There is also disclosed a lithographic apparatus configured to perform the method of feed-forward correction disclosed above.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains one or multiple processed layers.

Although specific reference may have been made above to the use of embodiments of the invention in the context of optical lithography, it will be appreciated that the invention may be used in other applications.

While specific embodiments of the invention have been described above, it will be appreciated that the invention may be practiced otherwise than as described.

The descriptions above are intended to be illustrative, not limiting. Thus, it will be apparent to one skilled in the art that modifications may be made to the invention as described without departing from the scope of the claims set out below.

## Claims

1. A method of feed-forward correction comprising:
determining feed-forward corrections based on measurements on a patterning device of a lithographic apparatus of a deformation parameter indicative of deformation of the patterning device before and after exposure by the lithographic apparatus of a substrate of a first series of substrates,
wherein the feed-forward corrections are to be applied during exposure by the lithographic apparatus of a substrate of a second series of substrates.

2. The method of claim 1, comprising:
measuring with a sensor of the lithographic apparatus the deformation parameter before and after exposure by the lithographic apparatus of the substrate of the first series of substrates.

3. The method of claim 1 or 2, comprising:
applying the feed-forward corrections to exposure by the lithographic apparatus of the substrate of the second series of substrates.

4. The method of any preceding claim, wherein the lithographic apparatus exposes the substrate of the first series of substrates with radiation patterned by the patterning device.

5. The method of any preceding claim, wherein the lithographic apparatus exposes the substrate of the second series of substrates with radiation patterned by the patterning device.

6. The method of any preceding claim, wherein the deformation parameter of the patterning device before exposure of the substrate to which the feed-forward corrections are to be applied is similar to the deformation parameter of the patterning device measured before exposure of the substrate of the first series of substrates.

7. The method of any preceding claim, wherein a difference between the deformation parameter of the patterning device measured before exposure of the substrate of the first series of substrates and the deformation parameter of the patterning device before exposure of the substrate to which the feed-forward corrections are to be applied is less than a difference between the deformation parameter of the patterning device before exposure of the substrate to which the feed-forward corrections are to be applied and the deformation parameter of the patterning device before exposure of another substrate of the second series of substrates.

8. The method of any preceding claim, wherein the substrate of the first series of substrates is an nth substrate of the first series of substrates that is exposed and the substrate of the second series of substrates to which the feed-forward corrections are applied is the nth substrate of the second series of substrates to be exposed.

9. The method of any preceding claim, wherein the feed-forward corrections are to be applied to exposure of respective fields of the substrate of a second series of substrates.

10. The method of any preceding claim, comprising:
inputting the measurements into a model such that the model outputs the feed-forward corrections.

11. The method of any preceding claim, comprising:
interpolating between the measured deformation parameter before the exposure and the measured deformation parameter after the exposure so as to determine the feed-forward corrections.

12. The method of any preceding claim, comprising:
applying a scaling factor to at least one of the measurements so as to account for change of the deformation parameter between when one of the measurements is made and when the exposure begins or ends.

13. The method of any preceding claim, comprising determining feed-forward corrections based on measurements of the deformation parameter before and after exposure by the lithographic apparatus of each of a plurality of substrates of the first series of substrates,
wherein the feed-forward corrections are to be applied during exposure by the lithographic apparatus of respective substrates of the second series of substrates.

14. The method of claim 13, wherein different feed-forward corrections are determined based on the measurements for different substrates of the first series of substrates, and the different feed-forward corrections are to be applied to respective different substrates of the second series of substrates.

15. The method of any preceding claim, wherein the substrate of the second series of substrates to which the feed-forward corrections are to be applied is to be exposed near a beginning of a time period for exposing the second series of substrates.

16. The method of any preceding claim, wherein the time period follows loading of the patterning device for use in the exposure of the second series of substrates.

17. The method of any preceding claim, wherein the time period follows an interval of at least a predetermined length after use of the patterning device for exposing any substrate.

18. The method of any preceding claim, wherein the feed-forward correction are determined for a subset of the first series of substrates, and to be applied to a corresponding subset of the second series of substrates.

19. The method of any preceding claim, wherein the feed-forward corrections are to be applied by moving at least one of a substrate table for moving the substrate and a support structure for moving the patterning device.

20. The method of any preceding claim, wherein the feed-forward corrections are to be applied by controlling at least one optical element of the lithographic apparatus.

21. The method of any preceding claim, wherein the deformation parameter is indicative of a location of at least one patterning device alignment mark of the patterning device.

22. The method of any preceding claim, wherein an inter-series pause between exposing successive series of substrates is longer than an inter-substrate pause between exposing successive substrates within a series of substrates.

23. The method of any preceding claim, comprising:
determining a pre-exposure correction based on the measurement of the deformation parameter before the exposure of the substrate of the first series of substrates,
wherein the pre-exposure correction is to be applied before the exposure of the substrate of the first series of substrates.

24. A controller for a lithographic apparatus for exposing substrates with radiation patterned by a patterning device, wherein the controller is configured to determine feed-forward corrections based on measurements on the patterning device of a deformation parameter indicative of deformation of the patterning device before and after exposure by the lithographic apparatus of a substrate of a first series of substrates,
wherein the feed-forward corrections are to be applied during exposure by the lithographic apparatus of a substrate of a second series of substrates.

25. A lithographic apparatus comprising the controller of claim 24.
